# EUROPEAN PATENT APPLICATION

(11) **EP 4 807 042 A1**
(43) Date of publication of application: **16.09.2026**
(21) Application number: 26153659.3
(22) Date of filing: 23.01.2026
(51) Int. Cl.: C23C 16/44, C23C 16/455, C23C 16/448

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 10.03.2025 JP 2025037528
(71) Applicant: Kokusai Electric Corporation, Tokyo 101-0045 (JP)
(72) Inventor: YAMANE, Yoma, Toyama-shi, Toyama, 9392393 (JP); ISHIBASHI, Kiyohisa, Toyama-shi, Toyama, 9392393 (JP); NOHARA, Shingo, Toyama-shi, Toyama, 9392393 (JP)
(74) Representative: Bardehle Pagenberg Partnerschaft mbB Patentanwälte Rechtsanwälte

(57) **Abstract**

A technique includes: (a) supplying a process gas, obtained by subjecting an object in liquid-phase or in solid-phase to a phase change, to a substrate in a process chamber along a path passing through a first section; and (b) after (a), performing: (b1) storing a purge gas in a second section; and (b2) exhausting the first section along a path that does not pass through the process chamber, while supplying the purge gas stored in the second section to the first section.

## Description

### CROSS-REFERENCE TO RELATED APPLICATION

This application is based upon and claims the benefit of priority from Japanese Patent Application No. 2025-037528, filed on March 10, 2025, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

In related art, as one step of a semiconductor device manufacturing process or a substrate processing process, there are cases where a film is formed on the surface of a substrate by performing a cycle including a step of supplying, to the substrate, a gas stored in a gas reservoir.

### SUMMARY

The present disclosure provides a technique capable of preventing adhesion of foreign matters (particles) to a substrate.

According to embodiments of the present disclosure, there is provided a technique, including: (a) supplying a process gas, obtained by subjecting an object in liquid-phase or in solid-phase to a phase change, to a substrate in a process chamber along a path passing through a first section; and (b) after (a), performing:(bl) storing a purge gas in a second section; and (b2) exhausting the first section along a path that does not pass through the process chamber, while supplying the purge gas stored in the second section to the first section.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace in a substrate processing apparatus suitably used in embodiments of the present disclosure, illustrating a process furnace portion in a longitudinal sectional view.
FIG. 2 is a schematic configuration diagram of a controller in the substrate processing apparatus suitably used in the embodiments of the present disclosure, illustrating a control system of the controller in a block diagram.
FIG. 3 is a flowchart illustrating a processing in the substrate processing apparatus according to the embodiments of the present disclosure.
FIG. 4 is a diagram illustrating an example of a tank purge step.
FIG. 5 is a diagram illustrating a modification of the tank purge step.
FIG. 6 is a diagram illustrating a modification of the tank purge step.
FIG. 7 is a diagram illustrating a modification of the substrate processing apparatus suitably used in the embodiments of the present disclosure.

### DETAILED DESCRIPTION

### <Embodiments of Present Disclosure>

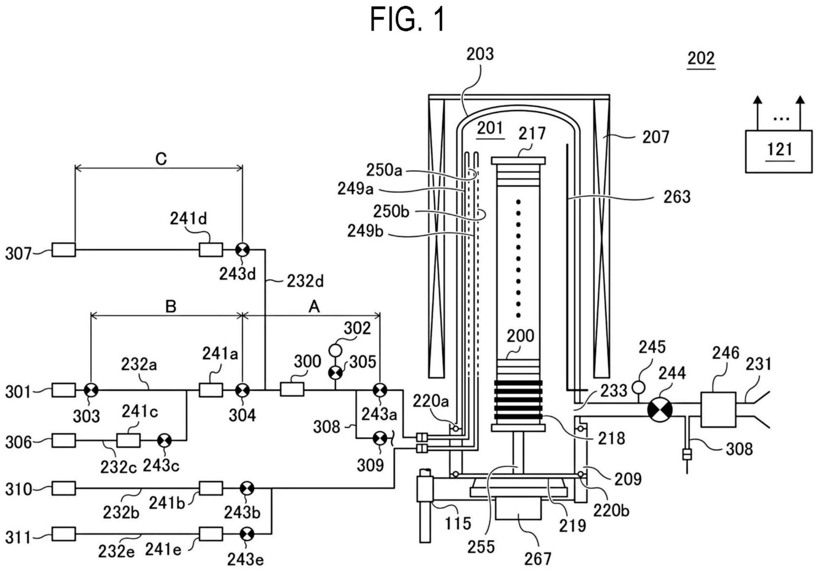

Hereinafter, embodiments of the present disclosure will be described mainly with reference to FIGS. 1 to 7. In addition, the drawings used in the following description are all schematic, and the dimensional relationships between respective elements, the proportions of the respective elements, and others illustrated in the drawings may not necessarily match with those in reality. Further, the dimensional relationships between respective elements and the proportions of respective elements may not necessarily match between multiple drawings.

### (1) Configuration of Substrate Processing Apparatus

As illustrated in FIG. 1, a process furnace 202 includes a heater 207 serving as a heating system (temperature regulator). A reaction tube 203 is arranged concentrically with the heater 207, in the heater 207. The reaction tube 203 is made of, for example, a heat-resistant material such as quartz, and is formed in a cylindrical shape with a closed upper end and an open lower end. A manifold 209 is arranged concentrically with the reaction tube 203 below the reaction tube 203. An O-ring 220a is provided as a seal between the manifold 209 and the reaction tube 203. A process container (reaction container) is mainly constituted by the reaction tube 203 and the manifold 209. A process chamber 201, which serves as a process space, is formed in a cylindrical hollow region of the process container. The process chamber 201 is configured to be capable of accommodating a wafer 200 serving as a substrate. The wafer 200 is disposed in the interior of the process chamber 201, and processing with respect to the wafer 200 is performed.

Nozzles 249a and 249b are provided inside the process chamber 201 to penetrate the sidewall of the manifold 209. Gas supply pipes (piping) 232a and 232b are respectively connected to the nozzles 249a and 249b.

The nozzles 249a and 249b are provided in an annular space in a plane view between the inner wall of the reaction tube 203 and the wafer 200 to extend upward in the stacking direction of the wafer 200 from the bottom to the top along the inner wall of the reaction tube 203. Gas supply holes 250a and 250b, which serve as supply ports for supplying gases, are respectively provided in the side surfaces of the nozzles 249a and 249b. A plurality of gas supply holes 250a and 250b are provided from the bottom to the top of the reaction tube 203.

A seal cap 219 is provided below the manifold 209, and serves as a furnace opening lid capable of airtightly closing a lower end opening of the manifold 209. An O-ring 220b is provided on the upper surface of the seal cap 219, and serves as a seal that abuts against a lower end of the manifold 209. A rotator 267 is installed below the seal cap 219 to rotate a boat 217 to be described later. A rotating shaft 255 of the rotator 267 passes through the seal cap 219 and is connected to the boat 217. The rotator 267 is configured to rotate the wafer 200 by rotating the boat 217. The seal cap 219 is configured to be vertically raised or lowered by a boat elevator 115, which serves as a lifting mechanism installed outside the reaction tube 203. The boat elevator 115 is configured to raise or lower the seal cap 219, thereby enabling loading and unloading of the boat 217 into and out of the process chamber 201. The boat elevator 115 is configured as a transport device (transporter) that transports the boat 217, i.e., the wafer 200, into and out of the process chamber 201.

The boat 217, which serves as a substrate support, is configured to support a plurality of wafers 200, e.g., 25 to 200 wafers, in such a state that the wafers 200 are aligned in a horizontal posture and in multiple stages, i.e., arranged at intervals along a vertical direction with the centers of the wafers 200 aligned with one another. The boat 217 is made of, for example, a heat-resistant material such as quartz. Heat insulation plates 218, which are made of a heat-resistant material such as quartz, are supported in multiple stages on the bottom of the boat 217. In addition, the notation of numerical ranges such as "25 to 200" in the present disclosure refers that both the lower and upper limit values are included in that range. Thus, for example, "25 to 200" implies "25 or more and 200 or less". The same applies to other numerical ranges.

A temperature sensor 263 is installed as a temperature detector inside the reaction tube 203. The internal temperature of the process chamber 201 falls within a desired temperature distribution by regulating energization to the heater 207 based on temperature information detected by the temperature sensor 263.

Next, details of a gas supply system and an exhaust system will be described.

The gas supply pipe 232a is provided, in order from the upstream direction, with a first supplier 301, a valve 303 that is an opening/closing valve, a mass flow controller (MFC) 241a that is a flow rate controller (flow rate control part), a valve 304, a tank 300 serving as a reservoir that stores a gas therein, a pressure sensor 302 that is a pressure gauge for measuring pressure, and a valve 243a. The reservoir is configured as a gas tank or a helical pipe having a larger gas capacity than a typical pipe. The pressure sensor 302 is configured to detect the internal pressure of the gas supply pipe 232a between the tank 300 and the valve 243a. The pressure sensor 302 is provided with a valve 305 that blocks and allows gas flow inside the pressure sensor 302.

The first supplier 301 is a gas source for supplying a first process gas. The first process gas is a gas that is likely to undergo a phase change into a liquid-phase or a solid-phase due to a decrease in temperature until it is supplied to the process chamber 201. For example, the first process gas is a gas obtained by causing a liquid-phase or solid-phase object to undergo a phase change at normal temperature and pressure. The first process gas is, for example, a precursor gas and is one of process gases. Further, a vaporizer or a similar one may be used as the first supplier 301, or an introduction port for the first process gas supplied from the outside of the substrate processing apparatus may be used.

A gas supply pipe 232c is connected between the valve 303 and the MFC 241a in the gas supply pipe 232a. Further, a gas supply pipe 232d is connected between the valve 304 and the tank 300 in the gas supply pipe 232a. The gas supply pipes 232c and 232d are provided, in order from the upstream direction, with a second supplier 306, a third supplier 307, MFCs 241c and 241d, and valves 243c and 243d.

The second supplier 306 and the third supplier 307 are gas sources for supplying an inert gas, respectively. The second supplier 306 and the third supplier 307 may be used in common. The inert gas supplied from the second supplier 306 and the third supplier 307 acts as a purge gas that purges gases remaining in the reaction tube 203, or as a carrier gas for the first process gas in a substrate processing step to be described later. Further, in a tank purge step to be described later, the inert gas acts as a purge gas that removes gases and particles existing in the gas supply pipe 232a, the MFC 241a, the tank 300, the pressure sensor 302, and others.

A gas exhaust pipe 308 is connected between the tank 300 and the valve 243a in the gas supply pipe 232a. A valve 309 is provided in the gas exhaust pipe 308. A downstream end of the gas exhaust pipe 308 is connected to an exhaust pipe 231 to be described later. The gas exhaust pipe 308 is configured to be capable of discharging the gas in the gas supply pipe 232a out of the process chamber 201 along a path that does not pass through the process chamber 201 by the opening and closing of the valve 309.

A first process gas supply system (also referred to as a precursor gas supply system) is mainly constituted by the gas supply pipe 232a, the valve 303, the MFC 241a, the valve 304, the tank 300, the pressure sensor 302, and the valve 243a. The first supplier 301 may also be included in the first process gas supply system. Further, a first inert gas supply system is mainly constituted by the gas supply pipe 232c, the MFC 241c, and the valve 243c. The second supplier 306 may also be included in the first inert gas supply system. Further, a second inert gas supply system is mainly constituted by the gas supply pipe 232d, the MFC 241d, and the valve 243d. The third supplier 307 may also be included in the second inert gas supply system. Further, the first inert gas supply system and the second inert gas supply system may be collectively referred to as an inert gas supply system. Further, the inert gas supply system may be included in the first process gas supply system. Further, a first process gas exhaust system is mainly constituted by the gas exhaust pipe 308 and the valve 309. The first process gas exhaust system may be included in the first process gas supply system.

The gas supply pipe 232b is provided, in order from the upstream direction, with a fourth supplier 310, an MFC 241b, and a valve 243b.

The fourth supplier 310 is a gas source for supplying a second process gas. The second process gas is a reaction gas or a modifying gas that reacts with the first process gas, and is one of process gases.

A gas supply pipe 232e is connected to the gas supply pipe 232b at the downstream side of the valve 243b. The gas supply pipe 232e is provided, in order from the upstream direction, with a fifth supplier 311, an MFC 241e, and a valve 243e.

The fifth supplier 311 is a gas source for supplying an inert gas. The inert gas supplied from the fifth supplier 311 acts as a purge gas that purges gases remaining in the reaction tube 203, or as a carrier gas for the second process gas in a substrate processing step to be described later.

A second process gas supply system (also referred to as a reaction gas supply system, a modifying gas supply system) is mainly constituted by the gas supply pipe 232b, the MFC 241b, and the valve 243b. The fourth supplier 310 may also be included in the second process gas supply system. Further, a third inert gas supply system is mainly constituted by the gas supply pipe 232e, the MFC 241e, and the valve 243e. The fifth supplier 311 may also be included in the third inert gas supply system. The third inert gas supply system may be included in the second process gas supply system.

The reaction tube 203 is provided with the exhaust pipe 231 for exhausting the internal atmosphere of the process chamber 201. The exhaust pipe 231 is connected to a vacuum pump 246, which serves as a vacuum-exhauster, via a pressure sensor 245, which serves as a pressure detector (pressure detection part) that detects the internal pressure of the process chamber 201, and via an auto pressure controller (APC) valve 244, which serves as a pressure regulator (pressure regulation part). The APC valve 244 may perform vacuum-exhaust and stopping vacuum-exhaust inside the process chamber 201 by being opened and closed while the vacuum pump 246 is operated. Further, the APC valve 244 is configured to be capable of regulating the internal pressure of the process chamber 201 by adjusting the opening degree thereof based on pressure information detected by the pressure sensor 245 while the vacuum pump 246 is operated. An exhaust system is mainly constituted by the exhaust pipe 231, the APC valve 244, and the pressure sensor 245. The vacuum pump 246 may also be included in the exhaust system.

The above-described gas exhaust pipe 308 is connected between the APC valve 244 and the vacuum pump 246 in the exhaust pipe 231. The gas exhaust pipe 308 may perform vacuum-exhaust and stopping vacuum-exhaust inside the gas supply pipe 232a by opening and closing the valve 309 while the APC valve 244 is closed and the vacuum pump 246 is operated. Further, the valve 309 is configured to be capable of regulating the internal pressure of the gas supply pipe 232a by adjusting the opening degree thereof based on pressure information detected by the pressure sensor 302 while the vacuum pump 246 is operated.

In the following, the region between the valve 304 and the valve 243a in the gas supply pipe 232a is referred to as a first section A. Further, the region between the valve 303 and the valve 304 in the gas supply pipe 232a is referred to as a second section B. Further, the region between the third supplier 307 and the valve 243d in the gas supply pipe 232d is referred to as a third section C. The first section A is connected at the upstream side to the second section B and at the downstream side to the process chamber 201 and the exhaust pipe 231. Further, the third section C is connected to the upstream side of the tank 300 of the first section A. Further, the first supplier 301 and the second supplier 306 are connected to the second section B. Further, the tank 300 and the pressure sensor 302 are provided in the first section A, and the MFC 241a is provided in the second section B.

In other words, the valve 304 is provided between the first section A and the second section B of the gas supply pipe 232a. Further, the valve 243a is provided between the first section A of the gas supply pipe 232a and the process chamber 201. Further, the valve 303 is provided between the first supplier 301 and the first section A in the gas supply pipe 232a. Further, the valve 309 is provided between the first section A in the gas exhaust pipe 308 and the exhaust pipe 231. Further, the valve 243c is provided between the second supplier 306 232c and the second section B in the gas supply pipe 232c.

The purge gas supplied from the second supplier 306 may be used for both purge inside the second section B, including purge around the MFC 241a, and purge inside the first section A including the tank 300. Further, the valve 304 may be commonly used for purge inside both the first section A and the second section B. Therefore, the supply system may be simplified. Further, the purge gas supplied from the third supplier 307 may be used for purge inside the first section A, including inside the tank 300.

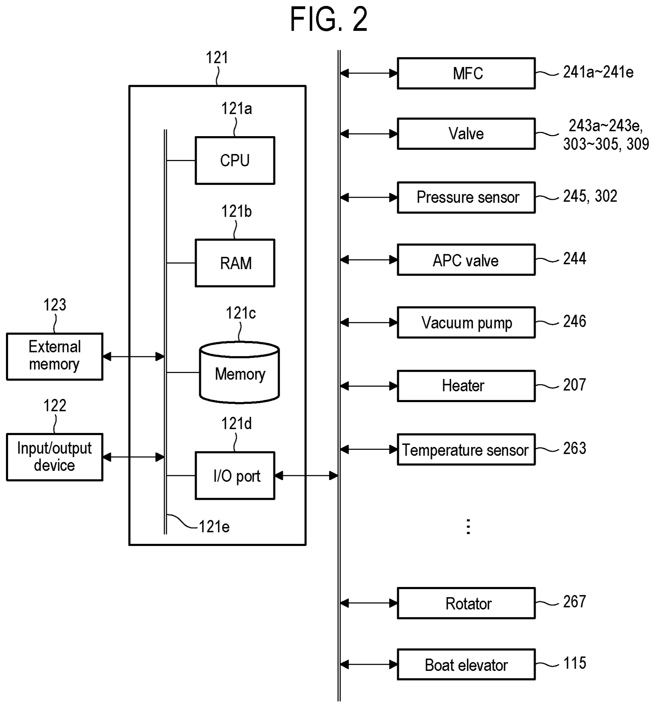

As illustrated in FIG. 2, the controller 121, which is a control part (control tool), is configured as a computer including a central processing unit (CPU) 121a, a random access memory (RAM) 121b, a memory 121c, and an I/O port 121d. The RAM 121b, the memory 121c, and the I/O port 121d are configured to be data-exchangeable with the CPU 121a via an internal bus 121e. The controller 121 is connected to an input/output device 122, which is configured as, for example, a touch panel.

The memory 121c is configured as, for example, a flash memory, a hard disk drive (HDD), a solid state drive (SSD), or a similar one. The memory 121c stores, in a readable manner, a control program for controlling the operation of the substrate processing apparatus, a process recipe describing the procedure, condition, and others of film formation to be described later, and others. The process recipe is a combination of respective procedures in film formation to be described later, which are to be executed by the controller 121 to obtain predetermined results, and functions as a program. Hereinafter, the process recipe, the control program, and others are collectively referred to simply as a program (program product). Further, the process recipe is also simply referred to as the recipe. The term "program" as used herein may refer to solely the process recipe, solely the control program, or both. The RAM 121b is configured as a memory area (work area) where the program, data, and others read by the CPU 121a are temporarily held.

The I/O port 121d is connected to the MFCs 241a to 241e, the valves 243a to 243e, 303 to 305, and 309, the pressure sensors 245 and 302, the APC valve 244, the vacuum pump 246, the heater 207, the temperature sensor 263, the rotator 267, the boat elevator 115, and others described above.

The CPU 121a is configured not only to read and execute the control program from the memory 121c but also to read the recipe from the memory 121c in response to, e.g., the input of an operation command from the input/output device 122. The CPU 121a is configured to enable the control of the adjustment of the flow rates of various gases by the MFCs 241a to 241e, the opening/closing operation of the valves 243a to 243e, 303 to 305, and 309, the opening/closing operation of the APC valve 244, the pressure adjustment operation by the APC valve 244 based on the pressure sensors 245 and 302, the startup and shutdown of the vacuum pump 246, the temperature adjustment operation of the heater 207 based on the temperature sensor 263, the rotation and rotational speed regulation of the boat 217 by the rotator 267, the lifting of the boat 217 by the boat elevator 115, and others.

The controller 121 may be configured by installing, onto the computer, the above-described program recorded and stored in an external memory (e.g., a magnetic disk such as a hard disk, an optical disk such as a CD, and a semiconductor memory such as a USB memory) 123. The memory 121c and the external memory 123 are configured as computer-readable recording media. Hereinafter, these are collectively referred to simply as the recording medium. The term "recording medium" as used herein may refer to solely the memory 121c, solely the external memory 123, or both. In addition, providing the program to the computer may be done using a communication facility such as the Internet or a dedicated line without using the external memory 123.

### (2) Processing Step

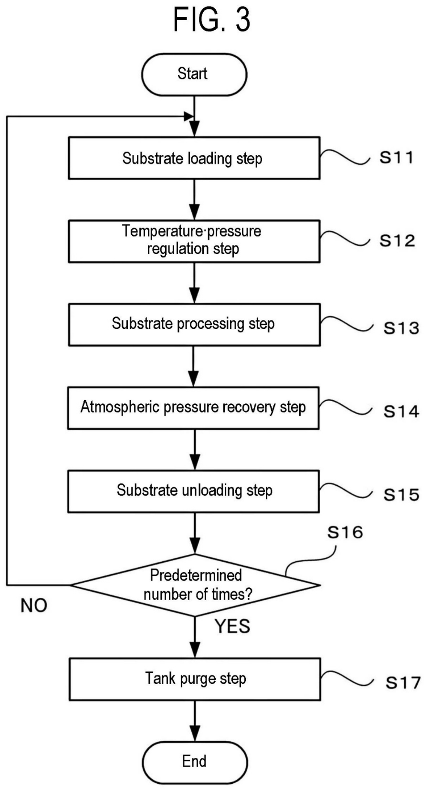

Next, a processing step of performing processing with respect to the above-described substrate processing apparatus as one step of a semiconductor manufacturing process will be described with reference to FIG. 3. In the following description, the operation of each part constituting the substrate processing apparatus is controlled by the controller 121.

The term "wafer" as used herein may refer to the wafer itself, or may refer to a stack including the wafer and a predetermined layer or film formed on a surface of the wafer. The term "surface of the wafer" as used herein may refer to the surface of the wafer itself, or may refer to the surface of a predetermined layer or film formed on the wafer. When it is described herein that "a predetermined layer is formed on the wafer", it may mean that "the predetermined layer is formed directly on the surface of the wafer itself", or may mean that "the predetermined layer is formed on a layer or film formed on the wafer". The term "substrate" as used herein is synonymous with the term "wafer".

### (Substrate Loading Step, S11)

When the boat 217 is charged with a plurality of wafers 200, as illustrated in FIG. 1, the boat 217 supporting the plurality of wafers 200 is raised by the boat elevator 115 and is loaded into the process chamber 201.

### (Temperature and Pressure Regulation Step, S12)

The interior of the process chamber 201, i.e., a space where the wafers 200 are present, is vacuum-exhausted (depressurized) to reach a desired pressure (degree of vacuum) by the vacuum pump 246. At this time, the internal pressure of the process chamber 201 is measured by the pressure sensor 245, and the APC valve 244 is feedback-controlled based on measured pressure information. The vacuum pump 246 is maintained in a constantly operated state at least until the wafers 200 are completely processed. Further, the wafers 200 inside the process chamber 201 are heated to reach a desired temperature by the heater 207. At this time, the degree of energization to the heater 207 is feedback-controlled based on temperature information detected by the temperature sensor 263 to achieve a desired temperature distribution inside the process chamber 201. The heating inside the process chamber 201 by the heater 207 is continued at least until the wafers 200 are completely processed. Further, rotation of the boat 217 and the wafers 200 by the rotator 267 is initiated. The rotation of the boat 217 and the wafers 200 by the rotator 267 is continued at least until the wafers 200 are completely processed.

### (Substrate Processing Step, S13)

Thereafter, a cycle including the following steps S1 to S4 is performed a predetermined number of times.

### [Supplying First Process Gas, Step S1]

First, a first process gas is supplied to the wafer 200 inside the process chamber 201. Specifically, by closing the valves 243a and 309 in advance and opening the valves 303 and 304, the first process gas, with a flow rate regulated by the MFC 241a, is stored in the tank 300 provided in the first section A. In other words, the first process gas is pressurized inside the tank 300. Then, by closing the valve 304 and opening the valve 243a, the first process gas stored in the tank 300 is supplied at once in a large amount to the wafer 200 inside the process chamber 201 through the nozzle 249a, and is exhausted from the exhaust pipe 231. Further, in order to prevent the first process gas from entering the nozzle 249b, the valve 243e is opened to flow an inert gas to the gas supply pipe 232e. The inert gas is supplied to the process chamber 201 through the gas supply pipe 232e and the nozzle 249b, and is exhausted from the exhaust pipe 231. In this step, the first process gas, obtained by causing a liquid-phase or solid-phase object to undergo a phase change, is supplied to the wafer 200 inside the process chamber 201 along a path including the first section A and the second section B located upstream of the first section A. At least partially simultaneously with step S1, the internal pressure of the first section A is measured using the pressure sensor 302 while the valve 305 is in an open state.

As the first process gas, for example, predetermined element-containing gases that contain a predetermined element, such as tungsten (W), titanium (Ti), molybdenum (Mo), tantalum (Ta), cobalt (Co), yttrium (Y), ruthenium (Ru), hafnium (Hf), zirconium (Zr), aluminum (Al), and silicon (Si), may be used. One or more of these may be used as the first process gas. Gases obtained by activating these gases using, e.g., a plasma may also be used as the first process gas.

The predetermined element-containing gases may be, for example, halogen-based predetermined element-containing gases that contain a predetermined element and a halogen element. Examples of the halogen-based predetermined element-containing gases may include hexachlorotungsten (WCl₆), hexafluorotungsten (WF₆), titanium tetrachloride (TiCl₄), titanium tetrafluoride (TiF₄), molybdenum pentachloride (MoCl₅), molybdenum pentafluoride (MoF₅), molybdenum dichloride dioxide (MoO₂Cl₂), molybdenum oxytetrachloride (MoOCl₄), tantalum pentachloride (TaCl₅), tantalum pentafluoride (TaF₅), cobalt difluoride (CoF₂), cobalt dichloride (CoCl₂), yttrium trifluoride (YF₃), yttrium trichloride (YCl₃), ruthenium trichloride (RuCl₃), ruthenium trifluoride (RuF₃), hafnium tetrachloride (HfCl₄), hafnium tetrafluoride (HfF₄), zirconium tetrachloride (ZrCl₄), zirconium tetrafluoride (ZrF₄), aluminum trichloride (AlCl₃), aluminum trifluoride (AlF₃), dichlorosilane (SiH₂Cl₂), 1,2-dichlorodisilane (Si₂H₄Cl₂), 1,1,1-trichlorodisilane (Si₂H₃Cl₃), 1,1,2-trichlorodisilane (Si₂H₃Cl₃), pentachlorodisilane (Si₂HCl₅), hexachlorodisilane (Si₂Cl₆), tetrafluorosilane (SiF₄), and others. Further, the predetermined element-containing gases may be gases containing, for example, monosilane (SiH₄), disilane (Si₂H₆), trisilane (Si₃H₈), and tetrasilane (Si₄H₁₀). One or more of these may be used as the predetermined element-containing gas.

Further, for example, an organic-based predetermined element-containing gas having a predetermined element and an organic ligand may be used as the predetermined element-containing gas. Examples of the organic-based predetermined-element containing gas may include hexadimethylaminoditungsten (W₂[N(CH₃)₂]₆), bis(tert-butylimido)bis(dimethylamido)tungsten((t-C₄H₉NH)₂W=(Nt-C₄H₉)₂), tetrakis(ethylmethylamino)titanium (Ti[N(C₂H₅)(CH₃)]₄), bis(ethylcyclopentadienyl)ruthenium (Ru(EtCp)₂), bis(cyclopentadienyl)ruthenium (Ru(Cp)₂), tetrakis(ethylmethylamino)hafnium (Hf[N(MeEt)]₄), tetrakis(diethylamino)hafnium (Hf[N(Et)₂]₄), tetrakis(dimethylamino)hafnium (Hf[N(Me)₂]₄), tris(dimethylamino)cyclopentadienylhafnium ((Cp)Hf[N(Me)₂]₃), tetrakis(ethylmethylamino)zirconium (Zr[N(Me)Cp]₄), tetrakis(diethylamino)zirconium (Zr[N(Et)₂]₄), tetrakis(dimethylamino)zirconium (Zr[N(Me)₂]₄), tris(dimethylamino)cyclopentadienylzirconium ((Cp)Zr[N(Me)₂]₃), trimethylaluminum (Al(CH₃)₃), tris(dimethylamino)silane (Si[N(CH₃)₂]₃, and others. One or more of these may be used as the predetermined element-containing gas.

As the inert gas, for example, a nitrogen (N₂) gas, or a noble gas such as argon (Ar), helium (He), neon (Ne), and xenon (Xe) may be used. One or more of these may be used as the inert gas.

### [Purging, Step S2]

After a first layer containing a predetermined element is formed on at least a part of the wafer 200, the valve 243a is closed to stop the supply of the first process gas. At this time, the APC valve 244 is fully opened, and the interior of the process chamber 201 is vacuum-exhausted by the vacuum pump 246 to remove any unreacted first process gas remaining in the process chamber 201 and reaction products generated by the reaction between the first process gas and the surface of the wafer 200 from the interior of the process chamber 201. At this time, the valves 243c to 243e remain open to maintain the supply of the inert gas to the process chamber 201. The inert gas acts as a purge gas.

### [Supplying Second Process Gas, Step S3]

Next, a second process gas, which reacts with the first layer, i.e., the surface (also referred to as the outermost surface) of the wafer 200, is supplied to the wafer 200 inside the process chamber 201. Specifically, the valve 243b is opened to flow the second process gas to the gas supply pipe 232b. The second process gas is regulated in flow rate by the MFC 241b, is supplied to the process chamber 201 through the nozzle 249b, and is exhausted from the exhaust pipe 231. At this time, the valve 243e is simultaneously opened to flow the inert gas to the gas supply pipe 232e. The inert gas is regulated in flow rate by the MFC 241e, is supplied along with the second process gas to the process chamber 201, and is exhausted from the exhaust pipe 231. Further, in order to prevent the second process gas from entering the nozzle 249a, the valve 243a is opened to flow the inert gas to the gas supply pipe 232a. The inert gas is supplied to the process chamber 201 through the gas supply pipe 232c and/or the gas supply pipe 232d, and the nozzle 249a, and is exhausted from the exhaust pipe 231.

By supplying the second process gas to the wafer 200 under the above-described condition, at least a part of the first layer formed on the wafer 200 is modified.

As the second process gas, for example, gases including a reducing gas, an oxidizing gas, a nitriding gas, a sulfiding gas, a seleniding gas, a telluriding gas, and others may be used. One or more of these may be used as the second process gas. Gases obtained by activating these gases using, e.g., a plasma may also be used as the second process gas. For example, when the first process gas is a predetermined element-containing gas and the second process gas is a reducing gas, a film composed of an elemental form of the predetermined element may be formed on the wafer 200. Further, for example, when the first process gas is a predetermined element-containing gas and the second process gas is any one of an oxidizing gas, a nitriding gas, a sulfiding gas, a seleniding gas, or a telluriding gas, an oxide film of the predetermined element, a nitride film of the predetermined element, a sulfide film of the predetermined element, a selenide film of the predetermined element, or a telluride film of the predetermined element may be formed on the wafer 200.

As the reducing gas, for example, one or more of gases including a hydrogen (H₂) gas, deuterium (D₂) gas, borane (BH₃) gas, diborane (B₂H₆) gas, carbon monoxide (CO) gas, ammonia (NH₃) gas, monosilane (SiH₄) gas, disilane (Si₂H₆) gas, trisilane (Si₃H₈) gas, monogermane (GeH₄) gas, digermane (Ge₂H₆) gas, and others may be used. As the oxidizing gas, for example, one or more of gases including oxygen (O₂), ozone (O₃), water vapor (H₂O), a mixed gas of H₂ and O₂, hydrogen peroxide (H₂O₂), nitrous oxide (N₂O), and others may be used. As the nitriding gas, for example, one or more of nitrogen-hydride-based gases such as an ammonia (NH₃) gas, diazene (N₂H₂) gas, hydrazine (N₂H₄) gas, and N₃H₈ gas may be used. As the sulfiding gas, for example, gases including sulfane (H₂S), disulfane (H₂S₂), diammonium sulfide ((NH₄)₂S), dimethyl sulfide ((CH₃)₂S), and others may be used. One or more of these gases may be used as the sulfiding gas. As the seleniding gas, for example, gases including selenane (H₂Se), diselenane (H₂Se₂), dimethylselenium ((CH₃)₂Se), and others may be used. One or more of these gases may be used as the seleniding gas. As the telluriding gas, for example, gases including tellane (H₂Te), ditellane (H₂Te₂), dimethyltellane ((CH₃)₂Te), and others may be used. One or more of these gases may be used as the telluriding gas.

### [Purging, Step S4]

After at least a part of the first layer on the wafer 200 is modified into a second layer, the valve 243b is closed to stop the supply of the second process gas. At this time, the APC valve 244 is fully opened, and the process chamber 201 is vacuum-exhausted by the vacuum pump 246 to remove any unreacted second process gas remaining in the process chamber 201 and any reaction products generated by the reaction between the second process gas and the surface of the wafer 200 from the interior of the process chamber 201. At this time, the valves 243c to 243e remain open to maintain the supply of the inert gas to the process chamber 201. The inert gas acts as a purge gas.

### (Execution for Predetermined Number of Times)

A cycle including the above-described steps S1 to S4 is performed a predetermined number of times (n times, where n is 1 or an integer of 2 or more). Thereby, a film containing a predetermined element with a predetermined thickness is formed on the wafer 200.

### (Atmospheric Pressure Recovery Step, S14)

An inert gas is supplied to the process chamber 201 from the respective gas supply pipes 232c and 232e, and is exhausted from the exhaust pipe 231. Thereby, the interior of the process chamber 201 is purged, after which the internal atmosphere of the process chamber 201 is replaced with the inert gas, and the internal pressure of the process chamber 201 is returned to atmospheric pressure.

### (Substrate Unloading Step, S15)

The seal cap 219 is lowered by the boat elevator 115 to open the lower end of the manifold 209. Then, the processed wafer 200 is unloaded from the lower end of the manifold 209 to the outside of the reaction tube 203 and out of the process chamber 201 while being supported by the boat 217. The processed wafer 200 is taken out from the boat 217.

### (Performing Predetermined Number of Times, S16)

A cycle including the above-described steps S11 to S15 is performed a predetermined number of times (m times, where m is 1 or an integer of 2 or more).

Here, in a case where the wafer 200 is processed using a gas obtained by causing a liquid-phase or solid-phase object, such as the above-described first process gas, to undergo a phase change, performing the substrate processing step multiple times may cause the first process gas to undergo a phase change into a liquefied or solidified object, forming particles inside the first section A and the second section B of the gas supply pipe 232a. In particular, a gas is likely to remain inside the tank 300, making it easier for the process gases and particles to remain and for the liquefied or solidified object to remain as particles.

The greater the amount of purge gas passing through the first section A per unit time, the more efficiently the gases and particles inside the first section A may be removed. However, if a large amount of purge gas is supplied to increase the internal pressure of the first section A when a large amount of gases and particles exists inside the first section A such as immediately after the first process gas is supplied, particles are likely to form due to gas aggregation. Therefore, the time required to remove particles may not be shortened effectively.

In embodiments of the present disclosure, after the cycle including the above-described steps S11 to S15 is performed a predetermined number of times, the following tank purge step S17 is performed.

### (Tank Purge Step, S17)

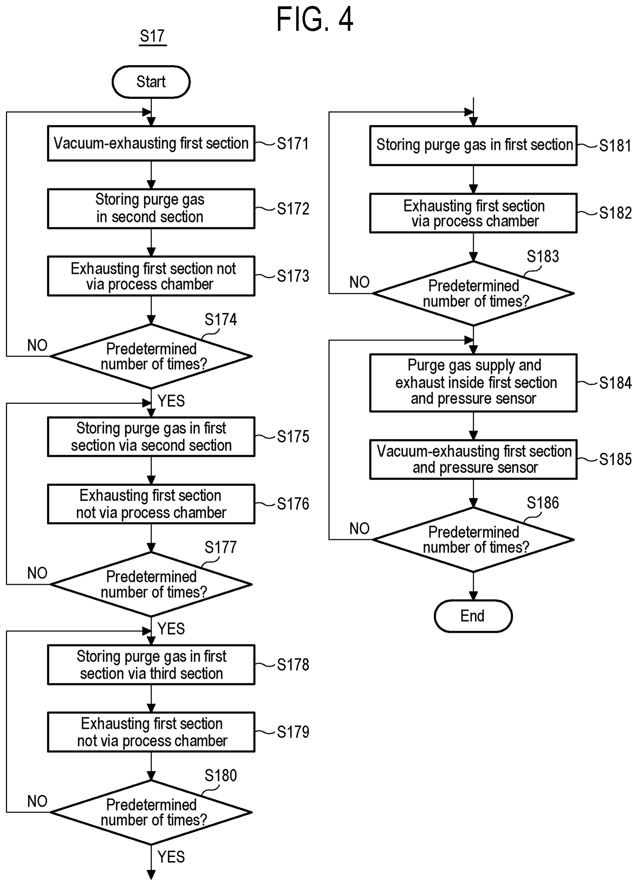

Next, an example of the tank purge step will be described with reference to FIG. 4.

### [Vacuum-Exhausting First Section, S171]

First, with the valves 304, 243a and 243d and the APC valve 244 closed and the vacuum pump 246 operating, the valve 309 is opened to vacuum-exhaust the first section A of the gas supply pipe 232a via the gas exhaust pipe 308 and the exhaust pipe 231 along a path that does not pass through the process chamber 201. In this step, the first section A is vacuum-exhausted before step S173 to be described later, to create a large pressure difference with the second section B at the start of step S173. This allows a large flow rate of purge gas to be supplied to the first section A within a short time in step S173 and discharged along a path that does not pass through the process chamber 201. Accordingly, the first process gas and particles inside the first section A are more easily removed.

A processing condition of step S171 is exemplified as follows:
Processing time: 1 to 30 seconds, desirably 5 to 25 seconds.

### [Storing Purge Gas in Second Section, S172]

With the valves 303 and 304 closed, the valve 243c is opened for a predetermined time to store a purge gas in the second section B of the gas supply pipe 232a. The purge gas, with a flow rate regulated by the MFC 241c, is stored in the second section B. At this time, the second section B becomes pressurized. It is desirable to perform step S172 at least partially simultaneously with the above-described step S171. This allows the time required for a purge step to be shortened. In addition, step S172 may be performed immediately after step S171.

A processing condition of step S172 is exemplified as follows:
Processing time: 1 to 30 seconds, desirably 5 to 25 seconds; and
Flow rate of purge gas supplied to the second section B: 0.1 to 2.0 slm, desirably 0.5 to 1.5 slm.

### [Exhausting First Section, S173]

Next, the valves 304 and 309 are opened to exhaust the gases and particles inside the first section A via the gas exhaust pipe 308 and the exhaust pipe 231 along a path that does not pass through the process chamber 201, while supplying the purge gas stored in the second section B to the first section A. At this time, a large amount of purge gas supplied to the first section A passes through the first section A within a short time. Therefore, the time during which the internal pressure of the tank 300 is high is extremely short. Accordingly, the gases and particles may be efficiently removed from inside the first section A including the tank 300, and the generation of particles caused by gas aggregation may be prevented.

A processing condition of step S173 is exemplified as follows:
Processing time: 1 to 30 seconds, desirably 5 to 25 seconds.

### [Performing Predetermined Number of Times, S174]

A cycle including the above-described steps S171 to S173 is performed a predetermined number of times (P₁ times, where P₁ is 1 or an integer of 2 or more). This allows the removal of gases and particles remaining inside the second section B, around the MFC 241a, and other regions. Further, in this step, by exhausting the gases and particles inside the first section A along a path that does not pass through the process chamber 201, movement of particles into the process chamber 201 may be prevented. For example, P₁ is 1 to 1000, desirably 10 to 800.

In the above-described steps S171 to S174, the valve 305 is opened to allow gas flow between the pressure sensor 302 and the first section A. At this time, since the time during which the internal pressure of the tank 300 is high is extremely short, allowing the gas flow between the pressure sensor 302 and the first section A is unlikely to damage the pressure sensor 302. Therefore, in the above-described steps S171 to S174, it is desirable to open the valve 305 and simultaneously remove gases and particles inside the pressure sensor 302.

### [Storing Purge Gas in First Section, S175]

Next, the purge gas is stored in the first section A via the second section B. Specifically, with the valves 243a, 303, 305 and 309 closed and the valve 304 opened, the valve 243c is opened for a predetermined time to store the purge gas in the first section A via the second section B. The purge gas, with a flow rate regulated by the MFC 241c, is stored in the first section A via the second section B. At this time, the first section A becomes pressurized.

A processing condition of step S175 is exemplified as follows:
Processing time: 1 to 30 seconds, desirably 5 to 25 seconds; and
Flow rate of purge gas supplied to the first section A: 0.1 to 2.0 slm, desirably 0.5 to 1.5 slm.

### [Exhausting First Section, S176]

Next, the valve 309 is opened to exhaust the purge gas stored in the first section A via the gas exhaust pipe 308 and the exhaust pipe 231 along a path that does not pass through the process chamber 201. That is, the gases and particles inside the first section A are exhausted.

A processing condition of step S176 is exemplified as follows:
Processing time: 1 to 30 seconds, desirably 5 to 25 seconds.

### [Performing Predetermined Number of Times, S177]

A cycle including the above-described steps S175 and S176 is performed a predetermined number of times (P₂ times, where P₂ is 1 or an integer of 2 or more). This allows the removal of gases and particles remaining inside the second section B, around the valve 303 and the MFC 241a, and other regions. For example, P₂ is 1 to 1000, desirably 10 to 800.

### [Storing Purge Gas in First Section, S178]

Next, a purge gas is stored in the first section A via the third section C. Specifically, with the valves 243a, 304, 305 and 309 closed, the valve 243d is opened for a predetermined time to store the purge gas in the first section A via the third section C. The purge gas, with a flow rate regulated by the MFC 241d, is stored in the first section A via the third section C. At this time, the first section B becomes pressurized.

A processing condition of step S178 is exemplified as follows:
Processing time: 1 to 30 seconds, desirably 5 to 25 seconds; and
Flow rate of purge gas supplied to the first section A: 0.1 to 2.0 slm, desirably 0.5 to 1.5 slm.

### [Exhausting First Section, S179]

Next, the valve 309 is opened to exhaust the purge gas stored in the first section A via the gas exhaust pipe 308 and the exhaust pipe 231 along a path that does not pass through the process chamber 201. That is, the gases and particles inside the first section A are exhausted.

A processing condition of step S179 is exemplified as follows:
Processing time: 1 to 30 seconds, desirably 5 to 25 seconds.

### [Performing Predetermined Number of Times, S180]

A cycle including the above-described steps S178 and S179 is performed a predetermined number of times (P₃ times, where P₃ is 1 or an integer of 2 or more). For example, P₃ is 1 to 1000, desirably 10 to 800.

Here, the gases and particles that could not be completely removed from the second section B in the above-described steps S171 to S174 may move into the first section A in step S175. By performing steps S175 to S180 after steps S171 to S174, and by pressurizing the first section A and then exhausting the first section A, the gases and particles that have moved from the second section B to the first section A may be more easily removed. Further, by exhausting the gases and particles inside the first section A along a path that does not pass through the process chamber 201, the movement of particles into the process chamber 201 may be prevented.

It is desirable that steps S175 to S180 are performed after steps S171 to S173 have been performed multiple times. Performing steps S175 to S180 when the gases and particles inside the first section A have been partially removed allows efficient removal of the gases and particles from inside the first section A while preventing the generation of particles caused by gas aggregation inside the first section A. In addition, either steps S171 to S173 or steps S175 to S180 may be performed alone. In this case as well, some of the above-described effects may be achieved.

### [Storing Purge Gas in First Section, S181]

Next, a purge gas is stored in the first section A. Specifically, with the valves 304, 305, 309 and 243a closed, the valve 243d is opened for a predetermined time to store the purge gas in the first section A via the third section C. The purge gas, with a flow rate regulated by the MFC 241d, is stored in the first section A via the third section C. At this time, the first section B becomes pressurized.

A processing condition of step S181 is exemplified as follows:
Processing time: 1 to 30 seconds, desirably 5 to 25 seconds; and
Flow rate of purge gas supplied to the first section a: 0.1 to 2.0 slm, desirably 0.5 to 1.5 slm.

### [Exhausting First Section, S182]

Next, the valve 243a is opened to exhaust the purge gas stored in the first section A along a path that passes through the process chamber 201. By storing the purge gas in the first section A to pressurize the first section A and then exhausting it, the gases and particles inside the first section A may be more easily removed.

A processing condition of step S182 is exemplified as follows:
Processing time: 1 to 30 seconds, desirably 5 to 25 seconds.

### [Performing Predetermined Number of Times, S183]

A cycle including the above-described steps S181 and S182 is performed a predetermined number of times (P₄ times, where P₄ is 1 or an integer of 2 or more). This allows the removal of gases and particles remaining inside the gas supply pipe 232a at the downstream side of the valve 243a, around the valve 243a, and other regions. Further, by performing steps S181 and S182 in a state where the gases and particles inside the first section A have been partially removed by steps S171 to S180, it becomes less likely for the gases and particles inside the first section A to be carried into the process chamber 201. For example, P₄ is 1 to 1000, desirably 10 to 800.

[Supplying Purge Gas in First Section·Pressure Sensor and Exhausting First Section· Pressure Sensor, S184]

Next, with the valves 304 and 243a closed, the valves 243d, 305 and 309 are opened to supply a purge gas to the first section A and the pressure sensor 302 while simultaneously exhausting the gas inside the first section A and inside the pressure sensor 302 via the gas exhaust pipe 308 and the exhaust pipe 231 along a path that does not pass through the process chamber 201. The purge gas, with a flow rate regulated by the MFC 241d, removes the gases and particles from inside the first section A and inside the pressure sensor 302.

A processing condition of step S184 is exemplified as follows:
Processing time: 1 to 30 seconds, desirably 5 to 25 seconds; and
Flow rate of purge gas supplied to the first section A: 0.1 to 2.0 slm, desirably 0.5 to 1.5 slm.

### [Vacuum-Exhausting First Section·Pressure Sensor, S185]

Next, the first section A and the pressure sensor 302 are vacuum-exhausted. Specifically, with the valves 304, 243a and 243d and the APC valve 244 closed and the vacuum pump 246 operating, the valve 309 is opened to vacuum-exhaust the first section A of the gas supply pipe 232a via the gas exhaust pipe 308 and the exhaust pipe 231 along a path that does not pass through the process chamber 201.

A processing condition of step S185 is exemplified as follows:
Processing time: 1 to 30 seconds, desirably 5 to 25 seconds.

### [Performing Predetermined Number of Times, S186]

A cycle including the above-described steps S184 and S185 is performed a predetermined number of times (P₅ times, where P₅ is 1 or an integer of 2 or more). By exhausting the gases and particles inside the first section A and inside the pressure sensor 302 along a path that does not pass through the process chamber 201, movement of particles into the process chamber 201 may be prevented. For example, P₅ is 1 to 1000, desirably 10 to 800.

By repeating the cycle including steps S184 and S185, the gases and particles inside the first section A and inside the pressure sensor 302 may be more easily removed. In addition, either step S184 or step S185 may be performed alone. In this case as well, at least some of the above-described effects may be achieved. For example, when performing only step S184, step S184 may be performed for 1 to 30,000 seconds, desirably 50 to 20,000 seconds. The same applies when performing only step S185.

Here, the longer the time during which the pressure sensor 302 remains at a high internal pressure, the more susceptible the pressure sensor 302 becomes to damage. Therefore, during at least steps S175 to S183 described above, it is desirable to close the valve 305 to block the gas flow between the pressure sensor 302 and the first section A, thereby preventing damage to the pressure sensor 302. Then, in the above-described steps S184 to S186, the valve 305 is opened to supply the purge gas to the first section A and to the pressure sensor 302, while the gases and particles inside the first section A and inside the pressure sensor 302 are exhausted via the gas exhaust pipe 308 and the exhaust pipe 231 along a path that does not pass through the process chamber 201. This allows efficient removal of the gases and particles from inside the pressure sensor 302.

Further, the time for performing the above-described steps S175 to S180 (hereinafter referred to as process c) is set to be longer than the times for performing steps S171 to S174 (hereinafter referred to as process b), steps S181 to S183 (hereinafter referred to as process d), and steps S184 to S186 (hereinafter referred to as process f). The reduction effect of particles per unit time is greatest in process c, followed by process b, process d, and process f. Therefore, it is desirable to set the time of process c longer than those of processes b, d, and f. Further, it is desirable to set the time of process b longer than those of processes d and f. Further, it is desirable to set the time of process f longer than that of process d. In addition, when process c is performed nc times and the time required for a single execution of process c is represented as tc, the time of process c may be represented as tc×nc. The same applies to the other processes.

### <Other Embodiments of Present Disclosure>

Embodiments of the present disclosure has been specifically described above. However, the present disclosure is not limited to the above-described embodiments, and may be changed in various ways without departing from the gist of the present disclosure.

### (Modification 1)

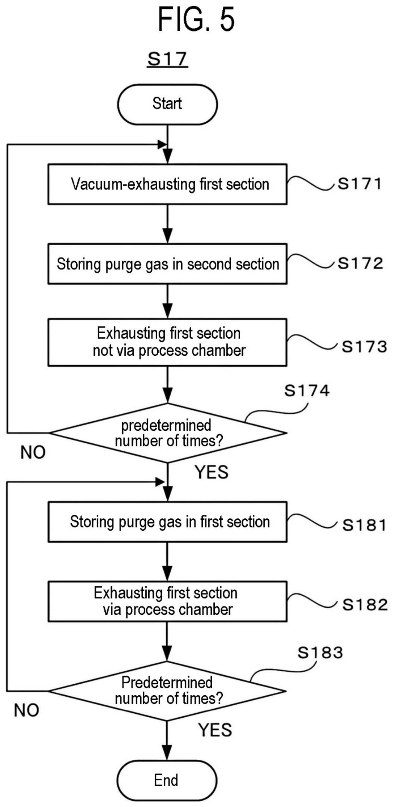

FIG. 5 illustrates a flow of Modification 1 of the tank purge step according to the present disclosure.

In this modification, during the above-described tank purge step S17, after performing process b, i.e., the above-described steps S171 to S174, process d, i.e., the above-described steps S181 to S183, is performed. In other words, processes c and f described above are not performed. In this modification as well, particles may be efficiently removed while preventing the generation of particles caused by aggregation of the process gas, and at least some of the same effects as in the above-described embodiments may be achieved.

### (Modification 2)

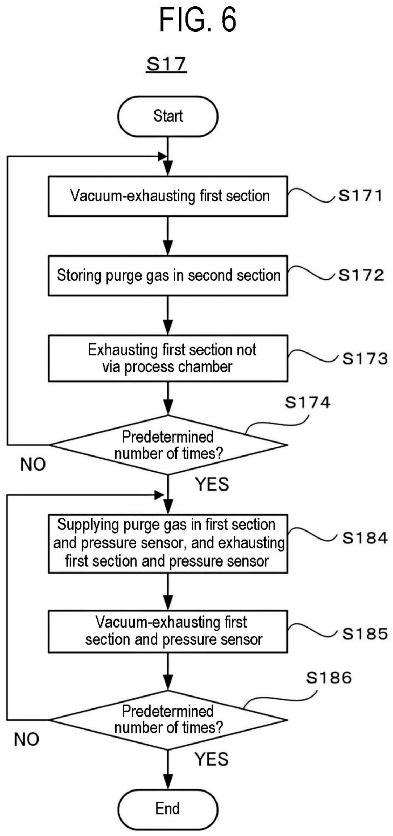

FIG. 6 illustrates a flow of Modification 2 of the tank purge step according to the present disclosure.

In this modification, during the above-described tank purge step S17, after performing process b, i.e., the above-described steps S171 to S174, process f, i.e., the above-described steps S184 to S186, is performed. In other words, processes c and d described above are not performed. In this modification as well, particles may be efficiently removed while preventing the generation of particles caused by aggregation of the process gas, and at least some of the same effects as in the above-described embodiments may be achieved.

### (Modification 3)

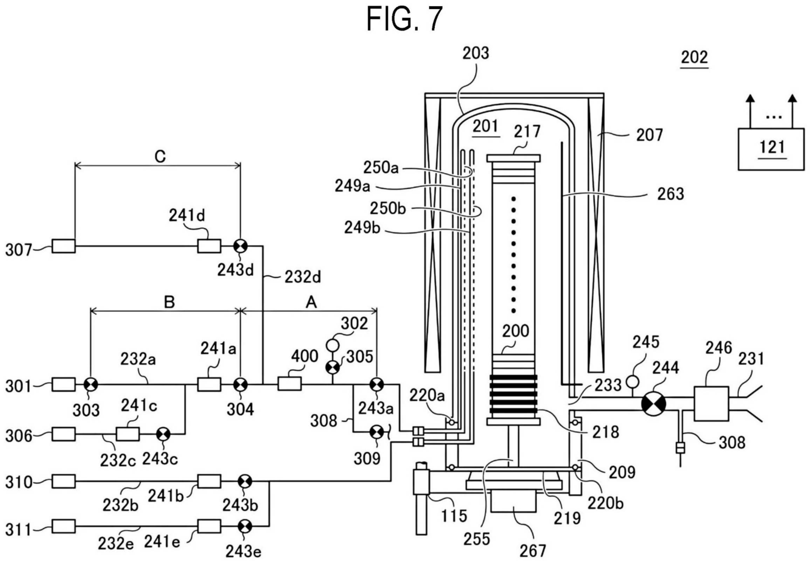

FIG. 7 illustrates a modification of the substrate processing apparatus to which the tank purge step S17 of the present disclosure is applied. In addition, in the substrate processing apparatus of this modification, the same reference numerals are given to components that are substantially the same as those described in FIG. 1, and the description thereof is omitted.

In this modification, as illustrated in FIG. 7, a filter 400 for removing a liquefied or solidified gas is provided between a merging portion of the first section A with the gas supply pipe 232d and the pressure sensor 302. Then, in the first process gas supply of step S1 in the above-described substrate processing step S13, the first process gas, obtained by causing a liquid-phase or solid-phase object to undergo a phase change is supplied to the wafer 200 inside the process chamber 201 via the filter 400 along a path that passes through the first section A and the second section B located upstream of the first section A.

In this modification as well, by performing the tank purge step S17 of the above-described embodiments or modifications, the first section A including the filter 400 may be purged. This allows efficient removal of particles from inside the filter 400 while preventing the generation of particles caused by gas aggregation. The same effects as in the above-described embodiments and modifications may be achieved.

In addition, in the above-described embodiments and modifications, a case has been described, where the gas supply pipe 232a is provided with the first inert gas supply system and the second inert gas supply system as the inert gas supply system, but the present disclosure is not limited thereto. The second inert gas supply system may be used as the first inert gas supply system. That is, the second section B, constituted by the gas supply pipe 232c, the MFC 241c, and the valve 243c, may not be provided, and the above-described third section C may be used as the second section B. The third supplier 307, the gas supply pipe 232d, the MFC 241d, and the valve 243d may be used instead of the second supplier 306, the gas supply pipe 232c, the MFC 241c, and the valve 243c. In this modification as well, the same effects as in the above-described embodiments and modifications may be achieved.

Further, in the above-described embodiments and modifications, a case has been described, where the tank 300 or the filter 400 is provided in the first section A, but the present disclosure is not limited thereto. The above-described embodiments or modifications may be applied in the same manner even in a substrate processing apparatus in which neither the tank 300 not the filter 400 is provided in the first section A. In this modification as well, by purging the first section A, the generation of particles caused by gas aggregation may be prevented, and particles may be efficiently removed, thereby achieving the same effects as in the above-described embodiments and modifications.

Further, in the above-described embodiments and modifications, a case has been described, where the first process gas supply system is purged in the tank purge step S17. However, the technique of the present disclosure is not limited thereto, and may also be applied in the same manner to a case where the second process gas supply system is purged. Further, the technique of the present disclosure may also be applied in the same manner to a case where a supply system of gases other than the first process gas and the second process gas exemplified above is purged.

In the above-described embodiments and modifications, an example has been described in which an inert gas (i.e., a gas treated as non-reactive such as an N₂ gas or a noble gas) is used as a purge gas. However, a purge gas may be a gas exhibiting a chemical action, such as a gas that oxidizes or reduces the surface of the wafer 200 or components or gases inside the process chamber 201. In addition, since an inert gas often has lower cost compared to a gas exhibiting a chemical action, using an inert gas as a purge gas may reduce the processing cost.

In the above-described embodiments and modifications, an example of forming a film using a batch type substrate processing apparatus that processes a plurality of substrates at once has been described. The present disclosure is not limited to the above-described embodiments and modifications, and may also be suitably applied when forming a film using a single wafer type substrate processing apparatus that processes one or a few substrates at once. Further, in the above-described embodiments and modifications, an example of forming a film using a substrate processing apparatus equipped with a hot wall type process furnace has been described. The present disclosure is not limited to the above-described embodiments and modifications, and may also be suitably applied when forming a film using a substrate processing apparatus equipped with a cold wall type process furnace.

When using these processing apparatuses as well, it is possible to perform each processing using the same process procedures and processing conditions as in the above-described embodiments and modifications, and to achieve the same effects as in the above-described embodiments and modifications.

The above-described embodiments and modifications may be used in combination as appropriate. The processing procedure and processing condition at this time may be the same as the processing procedures and processing conditions in the above-described embodiments and modifications, for example.

According to the present disclosure, it is possible to prevent adhesion of foreign matters (particles) to a substrate.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate (200) comprising:
(a) supplying a process gas, obtained by subjecting an object in liquid-phase or in solid-phase to a phase change, to the substrate (200) in a process chamber (201) along a path passing through a first section (A); and
(b) after (a), performing:
(b1) storing a purge gas in a second section (B); and
(b2) exhausting the first section (A) along a path that does not pass through the process chamber (201), while supplying the purge gas stored in the second section (B) to the first section (A).

2. The method of Claim 1, wherein (b) includes further performing:
(b0) before (b2), vacuum-exhausting the first section (A).

3. The method of Claim 1, further comprising:
(c) after (b), performing:
(c1) storing the purge gas in the first section (A); and
(c2) exhausting the first section (A) along the path that does not pass through the process chamber (201).

4. The method of Claim 3, further comprising:
(a') after (a), unloading the substrate (200) from the process chamber (201); and
(d) after (c) and (a' ), performing:
(d1) storing the purge gas in the first section (A); and
(d2) exhausting the first section (A) along a path passing through the process chamber (201).

5. The method of Claim 4, further comprising:
(e) at least partially simultaneously with (a), measuring a pressure of the first section (A) by a pressure gauge (302); and
(f) after (d), exhausting the first section (A) and the pressure gauge (302), while supplying the purge gas to the first section (A) and to the pressure gauge (302),
wherein, in (c) and (d), gas flow between the pressure gauge (302) and the first section (A) is blocked.

6. The method of Claim 5, wherein a time for performing (c) is set to be longer than those for performing (b), (d) and (f).

7. The method of Claim 5, wherein (f) includes:
(f1) exhausting the first section (A) and the pressure gauge (302), while supplying the purge gas to the first section (A) and to the pressure gauge (302); and
(f2) vacuum-exhausting the first section (A) and the pressure gauge (302).

8. The method of Claim 1 or 2, further comprising:
(a') after (a), unloading the substrate (200) from the process chamber (201); and
(d) after (b) and (a' ), performing:
(d1) storing the purge gas in the first section (A); and
(d2) exhausting the first section (A) along a path passing through the process chamber (201).

9. The method of Claim 1 or 2, further comprising:
(e) at least partially simultaneously with (a), measuring a pressure of the first section (A) by a pressure gauge (302); and
(f) after (b), purging the first section (A) and the pressure gauge (302).

10. The method of any one of Claims 1 to 9,
wherein (a) includes:
(a1) storing the process gas in a reservoir (300) provided in the first section (A); and
(a2) supplying the process gas stored in the reservoir (300) to the substrate (200), or
wherein, in (a), the process gas is supplied to the substrate (200) via a filter provided in the first section (A).

11. The method of any one of Claims 3 to 7, and 10, wherein a first supplier (301) that supplies the process gas, a second supplier (306) that supplies the purge gas, and the first section (A) are connected to the second section (B).

12. The method of Claim 11, wherein (c1) includes:
(c11) storing the purge gas in the first section (A) via the second section (B); and
(c12) storing the purge gas in the first section (A) via a third section (C) different from the second section (B), and
wherein in (c), after (c11) and (c2) are performed a predetermined number of times, (c12) and (c2) are performed a predetermined number of times.

13. A method of manufacturing a semiconductor device comprising the method of Claim 1.

14. A program that causes, by a computer, a substrate processing apparatus to perform a process comprising:
(a) supplying a process gas, obtained by subjecting an object in liquid-phase or in solid-phase to a phase change, to a substrate (200) in a process chamber (201) along a path passing through a first section (A); and
(b) after (a), performing:
(b1) storing a purge gas in a second section (B); and
(b2) exhausting the first section (A) along a path that does not pass through the process chamber (201), while supplying the purge gas stored in the second section (B) to the first section (A).

15. A substrate processing apparatus comprising:
a process chamber (201) in which a substrate (200) is disposed;
a first section (A) connected to the process chamber (201) and to an exhaust system (231, 244, 245);
a second section (B) connected to the first section (A), to a first supplier (301) that supplies a process gas obtained by subjecting an object in liquid-phase or in solid-phase to a phase change, and to a second supplier (306) that supplies a purge gas;
a plurality of valves (243a, 243c, 303, 304, 305) provided between the second section (B) and the first section (A), between the first section (A) and the process chamber (201), between the first supplier (301) and the first section (A), between the first section (A) and the exhaust system (231, 244, 245), and between the second supplier (306) and the second section (B); and
a controller configured to be capable of controlling the plurality of valves (243a, 243c, 303, 304, 305), so as to perform a process including:
(a) supplying the process gas to the substrate (200) along a path passing through the first section (A); and
(b) after (a), performing:
(b1) storing the purge gas in the second section (B); and
(b2) exhausting the first section (A) along a path that does not pass through the process chamber (201), while supplying the purge gas stored in the second section (B) to the first section (A).
